# EUROPÄISCHE PATENTSCHRIFT

(11) **EP 0 304 647 B1**
(45) Veröffentlichungstag und Bekanntmachung des Hinweises auf die Patenterteilung: **13.01.1993**
(21) Anmeldenummer: 88112013.3
(22) Anmeldetag: 26.07.1988
(51) Int. Cl.: H01L 39/12, H01L 39/24

(54) **Verfahren zur Herstellung von flexiblen band- oder folienförmigen Supraleitern aus keramischer Sintermasse**
Process for manufacturing ductile superconductive foils and tapes from a ceramic sintering mass
Procédé de fabrication de bandes et de feuilles supraconductrices ductiles d'alliage céramique

(30) Priorität: 28.08.1987 DE 3728767
(43) Veröffentlichungstag der Anmeldung: 01.03.1989
(73) Patentinhaber: Vacuumschmelze GmbH, 63450 Hanau (DE)
(72) Erfinder: Hillmann, Hans, Dr., D-6454 Bruchköbel (DE); Szulczyk, Andreas, D-6464 Linsengericht (DE)

(56) Entgegenhaltungen:
- SUPERCONDUCTOR SCIENCE AND TECHNOLOGY, Band 1, August 1988, Seiten 137-140, IOP Publishing Ltd, London, GB; M.A. LUSK et al.: "The fabrication of a ceramic superconducting wire"
- PROCEEDINGS OF THE 38TH ELECTRONIC COMPONENTS CONFERENCE, 9.-11. Mai 1988, Seiten 176-180, IEEE, Los Angeles, US; E.J.A. POPE et al.: "Matallorganic polymer route to superconducting Yttrium-Barium-Copper-Oxide wire"

## Beschreibung

Die Erfindung betrifft ein Verfahren zur Herstellung von flexiblen band- oder folienförmigen Supraleitern aus keramischer Sintermasse gemäß dem Oberbegriff des Patentanspruchs 1.

Aus keramischer Sintermasse bestehende Supraleiter haben den großen Vorteil, daß sie Sprungtemperaturen aufweisen, die über der Siedetemperatur des flüssigen Stickstoffs liegen. Hierzu verweisen wir auf die folgenden Literaturstellen : "Zeitschrift für Physik", Bd. 64 (1968) S. 189 und "Physical Review Letters", Vol. 58, Nr. 18 (1987) S. 1888, in denen mehrere Supraleiter auf Kupferoxid-Basis beschrieben sind. Das supraleitende Material wird hierbei aus geeigneten oxidischen Pulvern, wie beispielsweise Y₂O₃, BaCO₃ und CuO durch Mischen, Pressen, Sintern, ggf. mehrfaches Mahlen und thermische Zwischen- und Schlußbehandlung zur Erzielung der für die guten supraleitenden Eigenschaften verantwortlichen homogenen Gitterstruktur hergestellt. Auf diese Weise wird beispielsweise die eine sehr hohe Sprungtemperatur und eine sehr hohe kritische Magnetfeldstärke aufweisende Stoffgruppe YBa₂Cu₃O₇ in Form von Sinterkörpern oder gesinterten Schichten hergestellt.

Die in Form von Sinterkörpern oder Schichten vorliegenden supraleitenden Materialien können jedoch wegen ihrer Sprödigkeit nicht unmittelbar zu elektrischen Leitern, Spulen für Maschinen und Elektromagnete, magnetische Abschirmungen oder dergleichen weiterverarbeitet werden.

Ein weiterer Nachteil der bekannten Supraleiter auf Keramikbasis ist, daß sie zwar eine hohe Sprungtemperatur und ein hohes kritisches Magnetfeld aufweisen, jedoch ist ihre Stromtragfähigkeit extrem klein. Außerdem besitzen sie keine innere Stabilisierung durch hochleitendes Normalmaterial, wie z. B. Kupfer.

In der nicht vorveröffentlichten EP-A-0 296 379 wird daher bereits vorgeschlagen, daß zur Herstellung von draht- und/oder bandförmigen Supraleitern aus Keramikmaterial das supraleitende Material zu einem homogenen feinkörnigen Pulver zermahlen und in einem geeigneten Hüllkörper gefüllt wird. Der gefüllte Hüllkörper wird dann durch Kaltverformung auf die gewünschte Form und den gewünschten Querschnitt gebracht, wobei zur Einstellung der optimalen supraleitenden Eigenschaften nach der endgültigen Formgebung eventuell noch eine Schlußwärmebehandlung erforderlich sein kann.

Ferner wird in der nicht vorveröffentlichten EP-A-0 296 380 bereits vorgeschlagen, daß zur Erhöhung der kritischen Stromdichte in Supraleitern auf Keramikbasis, in die supraleitende Kristallgitterstruktur normalleitende oxidische Teilchen in der für die Haftwirkung optimalen Größe eingebaut werden.

Der Erfindung liegt die Aufgabe zugrunde, ein Verfahren zu schaffen, mit dem nicht nur die Herstellung von flexiblen band- oder folienförmigen Supraleitern aus keramischer Sintermasse erheblich erleichtert wird, sondern auch die erforderliche Stromtragfähigkeit und elektrische Stabilität gewährleistet sind. Diese Aufgabe wird gemäß der Erfindung durch das im Patentanspruch 1 angegebene Verfahren gelöst. Weitere Einzelheiten und Merkmale des erfindungsgemäßen Verfahrens ergeben sich aus den Unteransprüchen.

Durch die DE-PS 20 19 766 ist es zwar bekannt, aus feinstgemahlenen Teilchen, insbesondere auch solchen aus gesintertem Material, eine flexible, selbsttragende Folie herzustellen, in dem diesem Pulver trockenes feinteiliges Polytetrafluoräthylen hinzugefügt und dieses Gemisch so mechanisch durch Verwalzen verarbeitet wird, daß eine Matrix aus verflochtenem Polytetrafluoräthylen-Fasern entsteht. Hierbei wird die Bearbeitung bei einer Temperatur von 25 bis 200°C durchgeführt. Auf diese Weise werden insbesondere Blei enthaltende Folien für den Strahlen- und Lärmschutz, aber auch für Katalysatoren hergestellt.

Im Gegensatz zu diesen bekannten Folien, bei deren Anwendung die Beeinträchtigung anderer physikalischer Eigenschaften außer der Flexibilität von sekundärer technischer Bedeutung ist, spielt bei den Supraleitern auf keramischer Basis die Beeinträchtigung der supraleitenden Grundeigenschaften durch chemische Verunreinigungen eine entscheidende Rolle. So bewirken bereits geringste Verunreinigungen, z. B. von Silizium, bei diesen Stoffen den Verlust der Supraleitfähigkeit, so daß diese dann technisch wertlos werden.

Außerdem muß man erwarten, daß durch den Zusatz von polymeren Stoffen zu den keramischen Pulvern, die direkte elektrische und mechanische Kopplung der supraleitenden keramischen Sinterkörner unterbrochen wird, so daß ein intergranularer elektrischer Widerstand die durchgehende Supraleitfähigkeit zerstört.

Überraschenderweise hat sich jedoch gezeigt, daß die erfindungsgemäße Beimischung von Mischpolymerisat, insbesondere aus Äthylen und Vinylacetat, zum schlußwärmebehandelten, pulverförmigen, supraleitenden Material, beispielsweise YBa₂Cu₃O₇, nach dem Auswalzen zu Bändern oder Folien, sowohl die erwartete Flexibilisierung, als auch die Erhaltung der guten supraleitenden Eigenschaften bewirkte.

Technische Supraleiter, die im Magnetfeld hohe kritische Transportströme führen sollen, erfordern neben den hohen kritischen Temperaturen und hohen kritischen Magnetfeldstärken, welche beide sogenannte Stoffeigenschaften sind, auch die Fähigkeit durch Flußlinienverankerung hohe kritische Ströme tragen zu können. Diese Eigenschaft ist eine störabhängige Größe und kann erfindungsgemäß durch den Einbau normalleitender Bereiche von der Größe der supraleitenden Kohärenzlänge bzw. Eindringtiefe in die supraleitende Grundmasse bewirkt werden. Vorzugsweise werden dem pulverförmigen homogenen supraleitenden Material feinstdisperse Metalloxide mit hoher negativer freier Bindungsenthalpie beigefügt.

Weiterhin erfordert die technische Anwendung supraleitender Werkstoffe für den Bau supraleitender Magnete oder dergleichen, den Einbau oder die Umhüllung der supraleitenden Grundmasse von elektrisch hochleitendem Material für die elektrische Stabilisierung des supraleitenden Zustandes während des Betriebes. Dies kann erfindungsgemäß dadurch erfolgen, daß beim Auswalzen des mit organischen und oxidischen Zusätzen versehenen Materials oder anderen querschnittsvermindernden Verfahren hochleitfähige Metalldrähte, Drahtstücke, Bleche und/oder Drahtnetze beigefügt werden. Vorzugsweise bestehen diese beigefügten Materialien aus Kupfer. Allgemein kann das auszuwalzende bzw. zu verdichtende Material mehrmals querschnittsvermindernden Operationen unterzogen werden.

Die auszuwalzende bzw. zu verdichtende Masse kann dabei nach einem ersten Walz- bzw. Querschnittsreduzierungsschritt gefaltet und erneut im Querschnitt reduziert werden, so daß mehrere Schichten aus Supraleitermaterial und Stabilisierungsmetall in Sandwich-Form entstehen. Die Faltung und die Querschnittsverminderung können insbesondere auch mehrfach durchgeführt werden. Als vorteilhaft hat es sich erwiesen, wenn bei der Herstellung von Folien kreuzweise, d. h. abwechselnd im rechten Winkel gewalzt wird.

Die erfindungsgemäß hergestellten Bänder oder Folien können vorteilhafterweise zur Herstellung von Wicklungen für elektrische Geräte und Maschinen, insbesondere von Magnetwicklungen sowie zur Herstellung von magnetischen Abschirmungen eingesetzt werden.

## Patentansprüche

1. Verfahren zur Herstellung von flexiblen band- oder folienförmigen Supraleitern aus keramischer Sintermasse, wobei aus mehreren verschiedenen oxidischen Pulvern durch Mischen, Pressen, Sintern und Mahlen sowie gegebenenfalls mehrmalige thermische Behandlung ein feinkörniges homogenes supraleitendes Material hergestellt wird, dadurch gekennzeichnet, daß nach der Schlußwärmebehandlung dem pulverförmigen, homogenen supraleitenden Material ein Mischpolymerisat beigemischt und dieses Gemisch durch Walzen zu Bändern oder Folien verarbeitet wird.

2. Verfahren nach Patentanspruch 1, dadurch gekennzeichnet, daß ein Mischpolymerisat aus Äthylen und Vinylacetat verwendet wird.

3. Verfahren nach den Ansprüchen 1 oder 2, dadurch gekennzeichnet, daß in das homogene supraleitende Material normalleitende Bereiche von der Größe der supraleitenden Kohärenzlänge bzw. Eindringtiefe eingebaut werden.

4. Verfahren nach Anspruch 3, dadurch gekennzeichnet, daß dem pulverförmigen homogenen supraleitenden Material feinstdisperse Metalloxide mit hoher negativer freier Bindungsenthalpie beigemengt werden.

5. Verfahren nach einem der Ansprüche 1 bis 4, dadurch gekennzeichnet, daß beim Auswalzen des mit organischen und oxidischen Zusätzen versehenen Materials zu Bändern oder Folien hochleitfähige Metalldrähte, Drahtstücke, Bleche und/oder Drahtnetze beigefügt werden.

6. Verfahren nach einem oder mehreren der Ansprüche 1 bis 5, dadurch gekennzeichnet, daß das auszuwalzende bzw. zu verdichtende Material mehrmals querschnittsvermindernden Operationen unterworfen wird.

7. Verfahren nach Anspruch 6, dadurch gekennzeichnet, daß nach einem Walz- bzw. Querschnittsreduzierungsschritt das zuvor behandelte band- oder folienförmige Material gefaltet und erneut im Querschnitt reduziert wird.

8. Verfahren nach Anspruch 7, dadurch gekennzeichnet, daß die Faltung und die Querschnittsverminderung mehrfach durchgeführt werden.

9. Verfahren nach den Ansprüchen 6 oder 7, dadurch gekennzeichnet, daß bei der Herstellung von Folien kreuzweise, d. h. abwechselnd im rechten Winkel gewalzt wird.

10. Verwendung der nach den Verfahren gemäß den vorstehenden Ansprüchen hergestellten Bänder oder Folien zur Herstellung von Wicklungen für elektrische Geräte und Maschinen, insbesondere von Magnetwicklungen.

11. Verwendung der nach den Verfahren gemäß den Ansprüchen 1 bis 9 hergestellten Bänder oder Folien zur Herstellung von magnetischen Abschirmungen.

## Revendications

1. Procédé de fabrication de supraconducteurs en forme de bandes ou de feuilles souple en matière céramique frittée, selon lequel, partant de plusieurs poudres d'oxydes différents, on réalise par mélange, pressage, frittage et broyage et les cas échéants plusieurs traitements thermiques, une matière supraconductrice homogène à granulométrie fine, procédé caractérisé en ce qu'après le traitement thermique final, on ajoute à la matière supraconductrice, homogène pulvérulente, un polymérisat mélangé et on traite ce mélange par laminage sous forme de bandes ou de feuilles.

2. Procédé selon la revendication 1, caractérisé en ce que le polymérisat mélangé se compose d'éthylènes et d'acétate de vinyle.

3. Procédé selon les revendications 1 ou 2, caractérisé en ce qu'on intègre dans la matière supraconductrice, homogène, des zones à conductibilité normale, ayant des dimensions correspondant à la longueur de cohérence ou la profondeur de pénétration supraconductrices.

4. Procédé selon la revendication 3, caractérisé en ce qu'à la matière supraconductrice, homogène, pulvérulente, on ajoute des oxydes métalliques très finement dispersés, ayant une enthalpie libre de liaison négative, élevée.

5. Procédé selon l'une des revendications 1 à 4, caractérisé en ce qu'au moment du laminage de la matière contenant des additifs organiques et d'oxydes pour former des bandes ou des feuilles, on ajoute des fils métalliques, des morceaux de fil, des tôles et/ou des treillis de tôle très conducteurs.

6. Procédé selon l'une ou plusieurs des revendications 1 à 5, caractérisé en ce qu'on soumet la matière à laminer et à compacter à plusieurs opérations de réduction de section.

7. Procédé selon la revendication 6, caractérisé en ce qu'après une étape de laminage ou de réduction de section, on plie la matière en bandes ou en feuilles traitée préalablement et on effectue une nouvelle réduction de section.

8. Procédé selon la revendication 7, caractérisé en ce qu'on effectue plusieurs pliages et réductions de section.

9. Procédé selon les revendication 6 ou 7, caractérisé en ce que pour la fabrication de feuilles on lamine de manière croisée, c'est-à-dire en alternance, chaque fois à l'équerre.

10. Application de bandes ou de feuilles obtenues selon le procédé des revendications précédentes pour la fabrication d'enroulements d'appareils ou de machines électriques, notamment d'enroulements magnétiques.

11. Application de bandes ou de feuilles obtenues selon le procédé des revendications 1 à 9 pour la fabrication d'écrans magnétiques.

## Claims

1. A process for the production of flexible superconductors in the form of strips or sheets from a ceramic sintered compound, wherein a fine-grained, homogeneous, superconductive material is produced from a plurality of different oxidic powders by mixing, pressing, sintering and grinding and optionally multiple thermal treatment, characterised in that following the final thermal treatment a copolymer is admixed to the powdery, homogeneous, superconductive material, and this mixture is processed by rolling to form strips or sheets.

2. A process as claimed in Claim 1, characterised in that a copolymer of ethylene and vinyl acetate is used.

3. A process as claimed in Claims 1 or 2, characterised in that normally conductive zones, the size of which corresponds to that of the superconductive coherence length or penetration depth, are incorporated into the homogeneous, superconductive material.

4. A process as claimed in Claim 3, characterised in that finely dispersed metal oxides with a high negative free binding enthalpy are admixed to the powdery, homogeneous, superconductive material.

5. A process as claimed in one of Claims 1 to 4, characterised in that during the rolling out of the material, provided with organic and oxidic additives, to form strips or sheets, highly conductive metal wires, wire pieces, metal sheets and/or wire nets are added.

6. A process as claimed in one or more of Claims 1 to 5, characterised in that the material which is to be rolled out and compressed is subjected several times to cross-sectional reduction operations.

7. A process as claimed in Claim 6, characterised in that following a rolling or cross-sectional reduction step, the previously treated strip-like or sheet-like material is folded and reduced again in cross-section.

8. A process as claimed in Claim 7, characterised in that the folding and cross-sectional reduction are carried out several times.

9. A process as claimed in Claims 6 or 7, characterised in that in the case of the production of sheets, the rolling is carried out cross-wise, i.e. alternately at right angles.

10. The use of the strips or sheets produced in accordance with the processes claimed in the preceding claims, for the production of windings for electrical devices and machines, in particular magnetic windings.

11. The use of the strips or sheets produced in accordance with the processes claimed in Claims 1 to 9, for the production of magnetic screens.
